(19) Europäisches Patentamt
European Patent Office
Office européen des brevets

(11) EP 2 261 998 A1

(12) **EUROPEAN PATENT APPLICATION**
published in accordance with Art. 153(4) EPC

(43) Date of publication:
**15.12.2010 Bulletin 2010/50**

(51) Int Cl.:
***H01L 31/04*** *(2006.01)*

(21) Application number: **09724524.5**

(22) Date of filing: **13.02.2009**

(86) International application number:
**PCT/JP2009/052373**

(87) International publication number:
**WO 2009/119174 (01.10.2009 Gazette 2009/40)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **26.03.2008 JP 2008081878**

(71) Applicant: **The Nippon Synthetic Chemical Industry Co., Ltd.**
**Osaka-shi**
**Osaka 531-0076 (JP)**

(72) Inventors:
• **KATSUMA, Katsuhiko**
  **Osaka-shi**
  **Osaka 531-0076 (JP)**
• **HAYAKAWA, Seiichirou**
  **Osaka-shi**
  **Osaka 531-0076 (JP)**

(74) Representative: **Kuhnen & Wacker**
**Patent- und Rechtsanwaltsbüro**
**Prinz-Ludwig-Straße 40A**
**D-85354 Freising (DE)**

(54) **SOLAR CELL SUBSTRATE AND SOLAR CELL**

(57)    A solar cell substrate is provided for a solar cell excellent in photo-electric conversion efficiency.

The solar cell comprises a laminate including a glass plate [I] and a textured later [II], wherein the textured later [II] is composed of a resin obtained by curing a (meth) acrylic photo-curable composition (i), wherein a 1-cm square substrate center portion (a) of the solar cell substrate satisfies the following conditions (A) and (B) :

(A) an undulated surface of the textured later [II] in the substrate portion (a) has not more than two depressions each having a diameter of greater than 1.5 μm as observed in a 10-μm square field of view by an electronic microscope (SEM); and
(B) the undulated surface of the textured later [II] in the substrate portion (a) has a maximum level difference of not greater than 0.3 μm as observed in a 10-μm square field of view by an atomic force microscope (AFM).

FIG.3

**Description**

TECHNICAL FIELD

The present invention relates to a solar cell substrate which includes a textured later provided on a glass plate and having undulations, and to a solar cell. More specifically, the present invention relates to a solar cell substrate which ensures excellent photo-electric conversion efficiency of a solar cell, and to a solar cell employing the substrate.

BACKGROUND ART

In recent years, solar cells have been attracting attention as environmental measures for prevention of global warming and the like and as energy measures for fossil fuel substitute and the like. The solar cells are typically configured such that a transparent electrode of a metal oxide such as zinc oxide, tin oxide or indium tin oxide, a photo-electric conversion layer of a material selected from amorphous silicon, crystalline silicon, metal compounds and the like, and a back reflective electrode of a material selected from gold, silver, copper, platinum, palladium, aluminum, titanium and the like are provided in this order (a so-called superstrate type) or in the reverse order (a so-called substrate type) on a base plate. Among these solar cells, a solar cell employing the amorphous silicon for the photo-electric conversion layer is particularly attractive for silicon resource saving and cost reduction.

A production process of the solar cell employing the amorphous silicon typically utilizes a dry process. For example, the process includes the steps of forming a transparent electrode on a glass base plate by a sputtering method to prepare a transparent electrode-incorporated substrate, forming-afilm of the amorphous silicon by a CVD (chemical vapor deposition) method, and forming a back reflective electrode by a sputtering method. These steps are typically performed with heating up to 200°C or higher.

The photo-electric conversion efficiency is important for the solar cells. Needless to say, it is important to employ a photo-electric conversion material and a film formation method that ensure excellent conversion efficiency. A technique known to be effective for improvement of the conversion efficiency is such that a textured later having fine undulations on the order of wavelength is provided on a front surface of the base plate (to be formed with the transparent electrode) (see, for example, Patent Document 1). With the provision of the textured later, a surface of the transparent electrode present between the base plate and the photo-electric conversion layer has a geometry that permits easy light scattering. This increases the optical path length in the photo-electric conversion layer (so-called "light confinement effect"). As a result, light is effectively utilized, so that the solar cell has more excellent photo-electric conversion efficiency.

In general, the degree of the undulations of the textured later is defined by surface roughness (RMS), which should be controlled at a proper level. If the surface roughness is too small, the photo-electric conversion efficiency is not improved. On the other hand, an excessively great surface roughness is liable to cause cracking of the photo-conversion layer and, therefore, is not preferred.

A common method for controlling the surface roughness is such that a surface of the transparent electrode of the metal oxide formed on the glass base plate is roughened to have a fine undulation pattern. Methods recently employed for forming a texture having a proper surface roughness are such that, when a film of a metal oxide is formed on a glass base plate at a high temperature, the crystal growth of the metal oxide is controlled and such that, after a film of a metal oxide is formed on a glass base plate, the metal oxide film is etched.

However, it is difficult to control the crystal growth and the etching of the metal oxide, making it difficult to stably form the same texture pattern.

On the other hand, it is also proposed to transfer a texture onto a glass or plastic base plate by an embossing process or a gravure printing process (see, for example, Patent Document 2).

However, these processes fail to accurately transfer an undulation pattern during a transfer step, thereby suffering from a multiplicity of texture defects.

It is also proposed to form a resin texture pattern on a glass or plastic base plate through a photo process employing a photo-curable resin (see, for example, Patent Document 3).

However, the texture pattern to be formed by this process is a rectangular texture pattern. Therefore, it is difficult to expect the light confinement effect. Further, this process suffers from higher processing costs.

It is also proposed to form an aluminum film having a texture structure on a glass or plastic base plate at a temperature raised from 50°C to 200°C through a sputtering process employing a target of silicon-containing aluminum (see, for example, Patent Document 4).

However, this process permits natural growth of the texture, making it difficult to provide an intended pattern. Therefore, the light confinement effect is unsatisfactory.

Patent Document 1: JP-A-2003-298085
Patent Document 2: JP-A-2003-298086

Patent Document 3: JP-A-2003-298084
Patent Document 4: Japanese Patent No. 3792281

DISCLOSURE OF THE INVENTION

TECHNICAL PROBLEMS

In view of the foregoing, it is an object of the present invention to provide a solar cell substrate including a textured later, which has an efficient light confinement effect and ensures easy production thereof and stable formation of the same texture pattern to provide a solar cell having a highly improved photo-electric conversion efficiency.

SOLUTION TO PROBLEMS

The inventors of the present invention conducted intensive studies to solve the problems described above. As a result, the inventors found that a solar cell excellent in photo-electric conversion efficiency can be provided by employing a solar cell substrate which includes a laminate of a glass plate [I] and a textured later [II] composed of a resin obtained by curing a (meth)acrylic photo-curable resin (i) and having an undulation pattern having a smaller number of depressions each having a predetermined shape. Thus, the inventors attained the present invention. The present invention relates to a solar cell substrate which includes a laminate including a glass plate [I] and a textured later [II], wherein the textured later [II] is composed of a resin obtained by curing a (meth) acrylic photo-curable composition (i), wherein a 1-cm square substrate center portion (a) of the solar cell substrate satisfies the following conditions (A) and (B) :

(A) an undulated surface of the textured later [II] in the substrate portion (a) has not more than two depressions each having a diameter of greater than 1.5 $\mu$m as observed in a 10-$\mu$m square field of view by an electronic microscope (SEM); and
(B) the undulated surface of the textured later [II] in the substrate portion (a) has a maximum level difference of not greater than 0.3 $\mu$m as observed in a 10-$\mu$m square field of view by an atomic force microscope (AFM).

The present invention further relates to a solar cell substrate which includes a laminate including a glass plate [I] and a textured later [II], wherein the textured later [II] is composed of a resin obtained by curing a (meth)acrylic photo-curable composition (i), wherein a 1-cm square substrate center portion (a) of the solar cell substrate satisfies the following condition (C):

(C) where a distance L is defined as a distance between two points at which a line drawn parallel to a surface of the glass plate so as to allow an adjacent projection and depression of the textured later [II] to have the same sectional area intersecting an undulation profile of the textured later [II] on opposite sides of the depression in a section of the substrate portion (a) taken in a thicknesswise direction as observed by an electronic microscope (SEM) to measure an undulation pattern of the textured later [II] opposite from the glass plate [I], not more than two depressions each having a distance L greater than 1.5 $\mu$m are present in a given 10-$\mu$m wide area of the section of the substrate portion (a).

ADVANTAGEOUS EFFECTS OF THE INVENTION

The solar cell substrates according to the present invention each include a textured later having a precisely controlled texture pattern. Accordingly, the solar cell substrates are each excellent in photo-electric conversion efficiency and, therefore, useful as a substrate for a solar cell.

BRIEF DESCRIPTION OF THE DRAWINGS

Fig. 1 is a diagram showing observation of an inventive solar cell substrate by means of an atomic force microscope.
Fig. 2 is a diagram showing observation of a section of the inventive solar cell substrate by means of an electronic microscope.
Fig. 3 is a sectional view showing the construction of a solar cell substrate according to an embodiment of the present invention.

REFERENCE SIGNS LIST

| | |
|---|---|
| 1: | Glass plate |
| 2: | Textured later |
| 3: | Metal oxide film (of gallium-doped zinc oxide) |
| 4: | Photo-electric conversion layer |
| 5: | Back reflective electrode layer |
| 41: | p-Type layer |
| 42: | i-Type layer |
| 43: | n-Type layer |
| 51: | Transparent electrically conductive film (of gallium-doped zinc oxide) |
| 52: | Back metal electrode (silver) |
| 53: | Metal oxide film (of gallium-doped zinc oxide) |
| H: | Maximum level difference of undulation pattern |
| L: | Distance between two points at which a line drawn parallel to a glass surface so as to allow an adjacent projection and depression of the textured later [II] to have the same sectional area intersects an undulation profile of the textured later [II] on opposite sides of the depression |

BEST MODE FOR CARRYING OUT THE INVENTION

The present invention will hereinafter be described in detail.

In the present invention, the term " (meth) acrylate" is a generic term indicating acrylate and methacrylate, and the term "(meth)acrylic" is a generic term indicating acrylic and methacrylic.

A solar cell substrate according to the present invention is a solar cell substrate which includes a laminate including a glass plate [I] and a textured later [II], wherein the textured later [II] is composed of a resin obtained by curing a (meth)acrylic photo-curable composition (i), wherein a 1-cm square substrate center portion (a) of the solar cell substrate satisfies the following conditions (A) and (B):

(A) an undulated surface of the textured later [II] in the substrate portion (a) has not more than two depressions each having a diameter of greater than 1.5 $\mu$m as observed in a 10-$\mu$m square field of view by an electronic microscope (SEM); and

(B) the undulated surface of the textured later [II] in the substrate portion (a) has a maximum level difference of not greater than 0.3 $\mu$m as observed in a 10-$\mu$m square field of view by an atomic force microscope (AFM).

Examples of the glass plate [I] to be used in the present invention include a blue glass plate, reinforced white glass plate, and a white glass plate. Among these, the blue glass plate is often used because of its cost, and the white glass plate is excellent in transmittance. Where the glass plate is used for a solar cell outermost layer, the reinforced white glass plate is mainly used from the viewpoint of strength. The glass plate [I] preferably has a thickness of 0.1 to 10 mm, particularly preferably 0.5 to 8 mm, more preferably 1 to 7 mm. If the thickness of the glass plate [I] is too small, the substrate is liable to be broken. If the thickness of the glass plate [I] is too great, the thickness reduction of a solar cell tends to be difficult.

In the present invention, the textured later [II] preferably has a thickness of 0.3 to 30 $\mu$m, particularly preferably 0.4 to 20 $\mu$m, more preferably 0.5 to 10 $\mu$m, for photo-electric conversion efficiency. If the thickness of the textured later [II] is too small, an undulation pattern cannot be satisfactorily transferred onto the textured later, leading to a reduced photo-electric conversion efficiency. If the thickness of the textured later [II] is too great, a greater amount of a volatile gas will be emanated from the textured later during fabrication of a solar cell. This will reduce the photo-electric conversion efficiency of the solar cell.

In the present invention, the thickness of the textured later [II] having undulations means a maximum distance between a bottom surface (adjacent to the glass surface) of the textured later [II] and an apex of a projection of the undulated surface as measured in a thicknesswise direction of the textured later [II].

In the present invention, the textured later [II] is composed of the resin obtained by curing the (meth)acrylic photo-curable composition (i).

For example, the (meth)acrylic photo-curable composition (i) preferably contains a polyfunctional (meth)acrylate compound, a photopolymerization initiator and, optionally, a monofunctional (meth)acrylate compound. The textured later [II] is formed by photo-curing the photo-curable composition.

The polyfunctional (meth) acrylate compound may be a difunctional (meth)acrylate compound or a tri- or more-functional (meth)acrylate compound.

Examples of the difunctional (meth)acrylate compound include aliphatic compounds such as di(meth)acrylates modified with ethylene glycol (2 to 30 mol), di(meth)acrylates modified with propylene glycol (2 to 30 mol), butylene glycol di (meth) acrylate, neopentyl glycol di(meth)acrylate, 1,6-hexanediol di(meth)acrylate, glycerin di(meth)acrylate, pentaerythritol di(meth)acrylate, ethylene glycol diglycidyl ether di(meth)acrylate, diethylene glycol diglycidyl ether di (meth)acrylate, neopentyl glycol di(meth)acrylates modified with hydroxypivalic acid, di(meth)acrylates modified with isocyanuric acid ethylene oxide and 2-(meth)acryloyloxyethyl acid phosphate diester; alicyclic compounds such as bis(hydroxy)tricyclo[5.2.1.0$^{2,6}$]decane-di(meth)acryl ate, bis(hydroxy)tricyclo[5.2.1.0$^{2,6}$]decane-acrylate methacrylate, bis(hydroxymethyl)tricyclo[5.2.1.0$^{2,6}$]decane-di(meth )acrylate, bis(hydroxymethyl)tricyclo[5.2.1.0$^{2,6}$]decane-acrylat e methacrylate, bis(hydroxy)pentacyclo[6.5.1.1$^{3,6}$.0$^{2,7}$.0$^{9,13}$]pentadeca ne-di(meth)acrylate, bis(hydroxy)pentacyclo [6.5.1.1$^{3,6}$.0$^{2,7}$.0$^{9,13}$]pentadeca ne-acrylate methacrylate, bis(hydroxymethyl)pentacyclo[6.5.1.1$^{3,6}$.0$^{2,7}$.0$^{9,13}$]pen tadecane-di(meth)acrylate, bis(hydroxymethyl)pentacyclo[6.5.1.1$^{3,6}$.0$^{2,7}$.0$^{9,13}$]pen tadecane-acrylate methacrylate, 2,2-bis [4-(β-(meth)acryloyloxyethoxy)cyclohexyl]pro pane, 1,3-bis((meth)acryloyloxymethyl)cyclohexane, 1,3-bis((meth)acryloyloxyethyl)cyclohexane, 1,4-bis((meth)acryloyloxymethyl)cyclohexane, 1,4-bis((meth)acryloyloxyethyl)cyclohexane, di(meth)acrylates of hydrogenated bisphenol-A type modified with ethylene oxide (2 to 30 mol), di(meth)acrylates of hydrogenated bisphenol-F (2,2'-diphenylpropane) type modified with ethylene oxide (2 to 30 mol) and di(meth)acrylates of hydrogenated bisphenol-S type modified with ethylene oxide (2 to 30 mol); and aromatic compounds such as diglycidyl phthalate di(meth)acrylate, di(meth)acrylates of bisphenol-A type modified with ethylene oxide (2 to 30 mol), di(meth) acrylates of bisphenol-A type modified with propylene oxide (2 to 30 mol), di(meth)acrylates of bisphenol-F type modified with ethylene oxide (2 to 30 mol) and di(meth)acrylates of bisphenol-S type modified with ethylene oxide (2 to 30 mol).

Examples of the tri- or more-functional (meth)acrylate compound include aliphatic compounds such as trimethylolpropane tri(meth)acrylate, pentaerythritol tri(meth)acrylate, pentaerythritol tetra(meth)acrylate, dipentaerythritol penta(meth)acrylate, dipentaerythritol hexa(meth)acrylate, tri(meth)acryloyloxyethoxytrimethylol propane, glycerin polyglycidyl ether poly(meth)acrylates, tri(meth)acrylates modified with isocyanuric acid ethylene oxide, dipentaerythritol penta (meth)acrylates modified with ethylene oxide, dipentaerythritol hexa(meth)acrylates modified with ethylene oxide, pentaerythritol tri(meth)acrylates modified with ethylene oxide (1 to 30 mol) and pentaerythritol tetra(meth)acrylates modified with ethylene oxide (1 to 30 mol); and alicyclic compounds such as 1,3,5-tris((meth)acryloyloxymethyl)cyclohexane and 1,3,5-tris((meth)acryloyloxyethyloxymethyl)cyclohex ane.

Other examples of the polyfunctional (meth)acrylate compound to be used in the present invention include polyfunctional epoxy (meth)acrylate compounds, polyfunctional urethane (meth)acrylate compounds, polyfunctional polyester (meth)acrylate compounds and polyfunctional polyether (meth)acrylate compounds.

Among these polyfunctional (meth)acrylate compounds, the polyfunctional urethane (meth)acrylate compounds, bis(hydroxy)tricyclo[5.2.1.0$^{2,6}$]decane-di(meth)acryl ate, bis(hydroxymethyl)tricyclo[5.2.1.0$^{2,6}$]decane-di (meth )acrylate, pentaerythritol tetra(meth)acrylate and trimethylolpropane tri (meth) acrylate are preferred for the heat resistance and the linear expansion coefficient of the textured later [II]. The polyfunctional (meth)acrylate compounds having an aliphatic structure are more preferred, and the polyfunctional urethane (meth)acrylate compounds having an alicyclic structure, bis(hydroxy)tricyclo[5.2.1.0$^{2,6}$]decane-di(meth)acryl ate and bis(hydroxymethyl)tricyclo[5.2.1.0$^{2,6}$]decane-di(meth )acrylate are particularly preferred for suppression of the curing shrinkage of the textured later [II] and for reduction of waviness. It is particularly preferred to use these compounds in combination.

The polyfunctional urethane (meth)acrylate compounds to be advantageously used in the present invention are preferably prepared, for example, through a reaction of a polyisocyanate compound with a hydroxyl-containing (meth) acrylate compound, optionally, with the use of a catalyst such as dibutyltin dilaurate.

Specific examples of the polyisocyanate compound include aliphatic polyisocyanates such as ethylene diisocyanate and hexamethylene diisocyanate; polyisocyanate compounds having an alicyclic structure such as isophorone diisocyanate, bis(isocyanatomethyl)tricyclo[5.2.1.0$^{2,6}$]decane, norbornane isocyanatomethyl, 1,3-bis(isocyanatomethyl) cyclohexane, 1,4-bis(isocyanatomethyl)cyclohexane, bis(4-isocyanatocyclohexyl)methane, 2,2-bis(4-isocyanatocyclohexyl)propane, hydrogenated xylylene diisocyanate, hydrogenated diphenylmethane diisocyanate and a trimer of isophorone diisocyanate; and polyisocyanate compounds having an aromatic ring such as diphenylmethane diisocyanate, phenylene diisocyanate, tolylene diisocyanate and naphthalene diisocyanate.

Specific examples of the hydroxyl-containing (meth)acrylate compound include monofunctional (meth) acrylates such as 2-hydroxyethyl (meth) acrylate, 2-hydroxylpropyl (meth)acrylate and 2-hydroxybutyl (meth)acrylate, and polyfunctional (meth)acrylates such as 2-hydroxy-3-(meth)acryloyloxypropyl (meth)acrylate, pentaerythritol tri(meth)acrylate, dipentaerythritol penta(meth)acrylate and dipentaerythritol tri(meth)acrylate.

The polyfunctional urethane (meth)acrylate compounds obtained through the reaction of the polyisocyanate compound with the hydroxyl-containing (meth)acrylate compound may be used in combination. Among these reaction products, compounds having an alicyclic skeleton are preferred for water absorption, and acrylate compounds are further preferred for curing rate. Particularly, di- to nona-functional compounds, particularly di- to hexa-functional compounds, are preferred for heat resistance and flexural modulus.

In the present invention, the photo-curable composition for the textured later [II] may contain the monofunctional (meth)acrylate compound in an amount such that the curability is not impaired.

Examples of the monofunctional (meth)acrylate compound include aliphatic compounds such as ethyl (meth) acrylate, n-butyl (meth)acrylate, 2-hydroxyethyl (meth)acrylate, 2-hydroxypropyl (meth)acrylate, 4-hydroxybutyl (meth) acrylate, tetrahydrofurfuryl (meth)acrylate, 2-ethylhexyl (meth)acrylate and glycidyl (meth)acrylate; alicyclic compounds such as cyclohexyl (meth)acrylate, tert-butylcyclohexyl (meth)acrylate, tricyclodecyl (meth)acrylate, tricyclodecyloxymethyl (meth)acrylate, tricyclodecyloxyethyl (meth)acrylate, dicyclopentenyl (meth)acrylate, dicyclopentenyloxymethyl (meth)acrylate, dicyclopentenyloxyethyl (meth)acrylate, isobornyl (meth)acrylate, norbornyl (meth)acrylate, adamantyl (meth)acrylate, 2-methyl-2-adamantyl (meth)acrylate, 2-ethyl-2-adamantyl (meth)acrylate and 3-hydroxy-1-adamantyl (meth)acrylate; aromatic compounds such as benzyl (meth)acrylate; monofunctional epoxy (meth)acrylate compounds; monofunctional urethane (meth)acrylate compounds; monofunctional polyester (meth)acrylate compounds; and monofunctional polyether (meth)acrylate compounds.

These monofunctional (meth) acrylate compounds may be used either alone or in combination.

In general, any of these monofunctional (meth)acrylate compounds is preferably used in a proportion of not greater than 50 parts by weight, more preferably not greater than 30 parts by weight, particularly preferably not greater than 20 parts by weight, based on 100 parts by weight of the (meth) acrylic photo-curable composition (i). If the proportion of the monofunctional (meth)acrylate compound to be used is too great, a product formed from the resulting composition tends to have lower heat resistance.

In the present invention, the photopolymerization initiator is preferably used for curing the (meth)acrylic photo-curable composition. The photopolymerization initiator is not particularly limited as long as it can generate radicals upon irradiation with activation energy radiation, and various types of photopolymerization initiators are usable. Examples of the photopolymerization initiator include benzophenone, benzoin methyl ether, benzoin propyl ether, diethoxyacetophenone, 1-hydroxycyclohexyl phenyl ketone, 2,6-dimethylbenzoyldiphenylphosphine oxide, 2,4,6-trimethylbenzoyldiphenylphosphine oxide, 2,2-dimethoxy-1,2-diphenylethane-1-one (IRGACURE 651), 2-hydroxy-2-methyl-1-phenylpropane-1-one (DAROCUR 1173), 2-methyl-1-(4-methylthiophenyl)-2-morpholinopropane-1-one (IRGACURE 907) and bis (2,4,6-trimethylbenzoyl)phenylphosphine oxide (IRUGACURE 819), among which particularly preferred photopolymerization initiators are 1-hydroxycyclohexyl phenyl ketone, 2,4,6-trimethylbenzoyldiphenylphosphine oxide, 2,2-dimethoxy-1,2-diphenylethane-1-one (IRGACURE 651), 2-hydroxy-2-methyl-1- phenylpropane-1-one (DAROCUR 1173), 2-methyl-1-(4-methylthiophenyl)-2-morpholinopropane-1-one (IRGACURE 907) and bis(2,4,6-trimethylbenzoyl)phenylphosphine oxide (IRUGACURE 819). These photopolymerization initiators may be used either alone or in combination.

In general, any of these photopolymerization initiators is preferably used in a proportion of 0.1 to 10 parts by weight, more preferably 0.2 to 5 parts by weight, particularly preferably 0.2 to 3 parts by weight, based on 100 parts by weight of the (meth)acrylate compound (the total weight of the polyfunctional (meth)acrylate compound and the monofunctional (meth)acrylate compound, if the (meth)acrylate compound contains the monofunctional (meth)acrylate compound). If the proportion of the photopolymerization initiator to be used is too small, the polymerization rate tends to be reduced, resulting in insufficient polymerization. If the proportion of the photopolymerization initiator is too great, the textured later [II] tends to have a reduced light transmittance (due to yellowing) and a reduced mechanical strength.

A thermal polymerization initiator may be used in combination with the photopolymerization initiator.

Known thermal polymerization initiators are usable. Examples of the thermal polymerization initiators include hydroperoxides such as hydroperoxide, t-butyl hydroperoxide, diisopropylbenzene hydroperoxide and 1,1,3,3-tetramethylbutyl hydroperoxide; dialkyl peroxides such as di-t-butyl peroxide and dicumyl peroxide; peroxyesters such as t-butyl peroxybenzoate and t-butyl peroxy (2-ethylhexanoate) ; diacyl peroxides such as benzoyl peroxide; peroxycarbonates such as diisopropyl peroxycarbonate; and peroxides such as peroxyketals and ketone peroxides.

As required, the photo-curable composition to be used in the present invention may contain auxiliary components such as an antioxidant, an ultraviolet absorber, a leveling agent, a silane coupling agent, a tackifier, an antistatic agent, a flame retarder, a defoaming agent, a colorant, a release agent and various types of fillers in addition to the (meth) acrylate compound and the photopolymerization initiator described above.

The antioxidant is useful for preventing color change of the substrate, reduction in the mechanical strength of the substrate, and other degradation of the substrate during a high temperature process. Specific examples of the antioxidant include 2,6-di-t-butylphenol, 2,6-di-t-butyl-p-cresol, 2,4,6-tri-t-butylphenol, 2,6-di-t-butyl-4-s-butylphenol, 2,6-di-t-butyl-4-hydroxymethylphenol, n-octadecyl-p-(4'-hydroxy-3',5'-di-t-butylphenyl)propionate, 2,6-di-t-butyl-4-(N,N-dimethylaminomethyl)phenol, diethyl 3,5-di-t-butyl-4-hydroxybenzylphosphonate, 2,4-bis(n-octylthio)-6-(4-hydroxy-3', 5'-di-t-butylanilino)-1,3,5-triazine, 4,4-methylene bis(2,6-di-t-butylphenol), 1,6-hexanediol bis[3-(3,5-di-t-butyl-4- hydroxyphenyl)-propionate], bis(3,5-di-t-butyl-4-hydroxybenzyl)sulfide, 4,4'-di-thiobis(2,6-di-t-butylphenol), 4,4'-tri-thiobis(2,6-di-t-butylphenol), 2,2-thiodiethylene bis[3-(3,5-di-t-butyl-4-hydroxyphenyl)propionate], N,N'-hexamethylene bis(3,5-di-t-butyl-4-hydroxyhydrocinnamide, N,N'-bis[3-(3,5-di-t-butyl-4-hydroxyphenyl)propionyl]hydrazine, calcium (3,5-di-t-butyl-4-hydroxybenzyl)monoethyl phosphonate, 1,3,5-trimethyl-2,4,6-tris(3,5-dit-butyl-4-hydroxybenzyl)benzene, tris(3,5-di-t-butyl-4-hydroxyphenyl) isocyanurate, tris(3,5-di-t-butyl-4-hydroxybenzyl) isocyanurate, 1,3,5-tris-2-[3-(3,5-di-t-butyl-4-hydroxyphenyl)propionyloxy]ethyl isocyanurate, tetrakis[methylene-3-(3',5'-di-t-butyl-4-hydroxyphenyl)propionate] methane and diethyl 3,5-di-t-butyl-4-hydroxybenzylphosphite. These compounds may be used either alone or in combination. Among these, tetrakis[methylene-3-(3',5'-di-t-butyl-4-hydroxyphenyl)propionate]methane is particularly preferred because the effect of suppressing color tone is increased.

The ultraviolet absorber is useful for preventing degradation of the solar cell which may otherwise occur due to outdoor direct sunlight. The ultraviolet absorber is not particularly limited as long as it is soluble in the (meth)acrylate compound, and various types of ultraviolet absorbers are usable. Specifically, examples of the ultraviolet absorbers include those of salicylate type, benzophenone type, triazole type, hydroxybenzoate type and cyanoacrylate type. These ultraviolet absorbers may be used in combination. Among these, the ultraviolet absorbers of the benzophenone type and the triazole type, more specifically, (2-hydroxy-4-octyloxyphenyl)phenylmethanone and 2-benzotriazol-2-yl-4-tert-octylphenol, are preferred for compatibility with the (meth)acrylate compound.

In general, the proportion of the ultraviolet absorber is preferably 0.001 to 1 part by weight, particularly preferably 0.01 to 0.1 part by weight, based on 100 parts by weight of the (meth)acrylate compound (the total weight of the polyfunctional (meth)acrylate compound and the monofunctional (meth)acrylate compound, if the (meth)acrylate compound contains the monofunctional (meth)acrylate compound). If the proportion of the ultraviolet absorber is too small, the solar cell tends to have lower light resistance. If the proportion of the ultraviolet absorber is too great, the time required for curing the photo-curable composition is increased, leading to the possibility of insufficient curing.

The leveling agent is useful for improving the transfer accuracy in the transfer of the undulation pattern. Specifically, various types of leveling agents are usable as long as they are soluble in the (meth)acrylate compound. Specific examples of the leveling agent include polyether-modified polydimethylsiloxanes, acrylic polymers and polyester-modified polydimethylsiloxanes. These leveling agents may be used in combination. Among these, the polyether-modified polydimethylsiloxanes are preferred for leveling capability.

The proportion of the leveling agent is typically 0.001 to 1 part by weight, preferably 0.01 to 0.5 parts by weight, particularly preferably 0.05 to 0.3 parts by weight, based on 100 parts by weight of the (meth)acrylate compound (the total weight of the polyfunctional (meth)acrylate compound and the monofunctional (meth)acrylate compound, if the (meth)acrylate compound contains the monofunctional (meth)acrylate compound). If the proportion of the leveling agent is too small, it is impossible to impart the photo-curable composition with the leveling capability. If the proportion of the leveling agent is too great, the photo-curable composition tends to be insufficiently cured.

The (meth)acrylic photo-curable composition thus obtained is irradiated with activation energy radiation, preferably ultraviolet radiation, to be thereby photo-cured. Thus, the textured later [II] is obtained.

In the present invention, the textured later [II] is formed as having undulations on the glass plate [I] by photocuring the (meth)acrylic photo-curable composition (i). Thus, a laminate including the glass plate [I] and the textured later [II] having the undulations is provided.

In the present invention, the 1-cm square substrate center portion (a) of the solar cell substrate including the laminate is required to satisfy the following conditions (A) and (B):

(A) the undulated surface of the textured later [II] in the substrate portion (a) has not more than two depressions each having a diameter of greater than 1.5 $\mu$m as observed in a 10-$\mu$m square field of view by an electronic microscope (SEM); and

(B) the undulated surface of the textured later [II] in the substrate portion (a) has a maximum level difference of not greater than 0.3 $\mu$m as observed in a 10-$\mu$m square field of view by an atomic force microscope (AFM).

In the present invention, the 1-cm square substrate center portion (a) of the solar cell substrate is obtained by cutting out a 1-cm square portion of a solar cell substrate of a solar cell module about an intersection of diagonal lines in a plane of the substrate.

A given portion of the undulated surface of the substrate portion thus cut out is observed by an SEM and an AFM, and a given section of the substrate portion thus cut out is observed by the SEM. Edges of the substrate portion in which the textured later of the solar cell is lost by the cutting are not observed.

For the observation of the undulated surface of the textured later [II] by the SEM, a metal (e.g., gold) is deposited on the textured later [II] to impart the textured later [II] with electrical conductivity, and then the solar cell substrate is placed on an SEM stage and observed from just above with the SEM stage tilted 45 degrees with respect to a horizontal plane. The observation is carried out in vacuum, and a magnification of X10,000 and an acceleration voltage of 15 kV are typically employed as the observation conditions.

Where a given 10-$\mu$m square area in an SEM image thus obtained is observed, projections and depressions are typically present at a pitch of about 0.1 to about 1 $\mu$m. However, a defective portion (depression) having a diameter of greater than 1.5 $\mu$m with no undulation texture pattern is often observed. The term "diameter" herein means an average of a major diameter and a minor diameter of the depression.

For the improvement of the photo-electric conversion efficiency, the number of such depressions having a diameter of greater than 1.5 μm should be not more than two. The number of such depressions having a diameter of greater than 1.5 μm is preferably not more than one, particularly preferably zero.

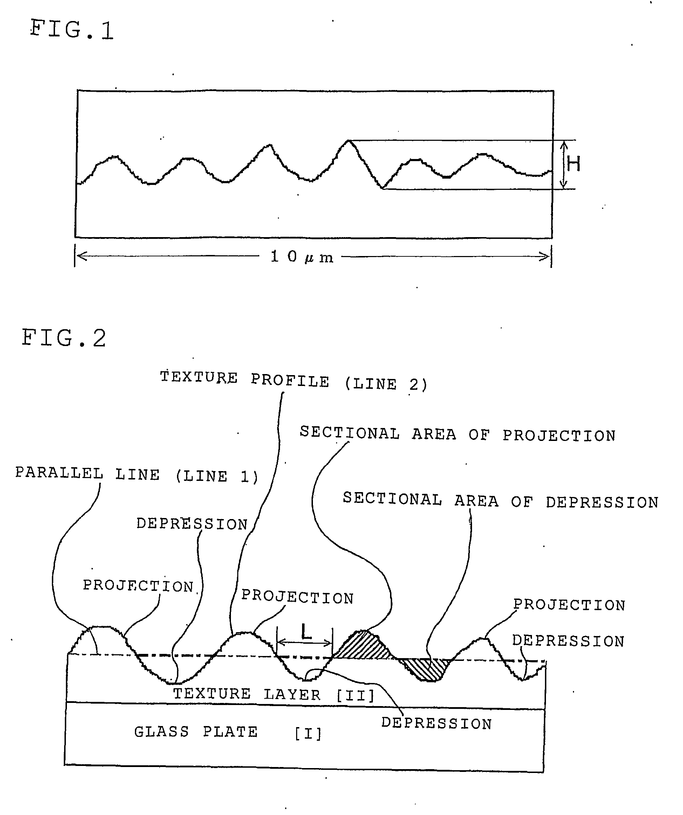

Where the given 10-μm square area of the undulated surface of the textured later [II] is observed by the AFM, the maximum level difference H of the undulated surface in a given 10-μm width area should be not greater than 0.3 μm for the improvement of the photo-electric conversion efficiency. The maximum level difference H is preferably not greater than 0.2 μm (see Fig. 1). The maximum level difference H of the undulated surface means a maximum height as measured from the lowermost point of a depression to the uppermost point of a projection adjacent to the depression in the undulated surface (indicated by "H" in Fig. 1).

In the present invention, the 1-cm square substrate center portion (a) of the solar cell substrate including the laminate preferably satisfies the following condition (C):

(C) where a distance L is defined as a distance between two points at which a line drawn parallel to a surface of the glass plate so as to allow an adjacent projection and depression of the textured later [II] to have the same sectional area intersects an undulation profile of the textured later [II] on opposite sides of the depression in a section of the substrate portion (a) taken in a thicknesswise direction as observed by an electronic microscope (SEM) to measure an undulation pattern of the textured later [II] opposite from the glass plate [I], not more than two depressions each having a distance L of greater than 1.5 μm are present in a given 10-μm wide area of the section of the substrate portion (a). The number of such depressions is preferably not greater than one, more preferably zero.

The line drawn parallel to the glass surface so as to allow an adjacent projection and depression of the textured later [II] to have the same sectional area is defined as a parallel line shown in Fig. 2. The distance L between the two points at which the line intersects the undulation profile (see Fig. 2) of the textured later [II] on opposite sides of the depression is defined as a distance L shown in Fig. 2.

The condition in which the number of the depressions each having the aforementioned specific geometry is not greater than two means that the textured later is evenly textured with no defect and the entire surface of the textured later is excellent in light confinement effect.

If the number of the depressions each having the aforementioned specific geometry is too great, the light confinement property is deteriorated, leading to lower photo-electric conversion efficiency.

In the present invention, the aforementioned condition (A) is satisfied, for example, by a method of allowing the (meth)acrylic photo-curable composition (i) to have a volumetric curing shrinkage percentage of 6 to 8 %, or by a method of reducing the thickness of the textured later [II]. Particularly, the method of allowing the (meth) acrylic photo-curable composition (i) to have a volumetric curing shrinkage percentage of 6 to 8 % is preferred for proper adhesion between the textured later [II] and the glass plate [I]. Particularly, the volumetric shrinkage percentage is preferably 6.1 to 7.5 %, more preferably 6.2 to 7 %. If the volumetric shrinkage percentage is too high or too low, it is impossible to transfer a fine undulation pattern from a matrix die onto the textured later [II] with higher reproducibility.

A reason for this will be described below.

Where the undulation pattern is transferred from a support base (matrix die), a liquid photo-curable composition having the lowest possible volumetric curing shrinkage percentage is generally used. If the volumetric shrinkage percentage is higher, the liquid composition contacts the support base before the curing, but shrinks to be separated from the support base after the curing. Therefore, the geometry transferability tends to be poorer.

In the case of the textured later for the solar cell, however, the undulation pattern is very fine on the order of wavelength. Therefore, the cured product cannot be released from the support base, unless the volumetric shrinkage percentage is relatively high. Even if the cured product can be released, the cured product is liable to partly remain on the support base, making it impossible to reuse the support base. Further, the substrate is liable to have a defective texture. These phenomena occur supposedly because the support base and the cured product firmly adhere to each other with a greater interface area therebetween.

A conceivable approach to improvement of the releasability is to form a release layer on the support base without filling the undulation pattern of the support base. However, the release layer is liable to come off during repeated transfer. Therefore, the releasability is reduced as the transfer is repeatedly carried out. Another conceivable approach is to add a release agent to the photo-curable composition. However, this approach is not preferred because the adhesion between the cured product and the glass substrate is reduced.

In order to ensure both the transferability and the releasability, the volumetric curing shrinkage percentage of the photo-curable composition is preferably controlled in a proper range. In the present invention, the texture pattern can be precisely transferred at a higher productivity by controlling the volumetric shrinkage percentage.

In the present invention, the volumetric shrinkage percentage (%) is calculated from the following expression (1) by using the specific gravity (D1) of the (meth) acrylic photo-curable composition (i) and the specific gravity (D2) of a product obtained by curing the (meth)acrylic photo-curable composition (i):

EP 2 261 998 A1

$$\text{Volumetric shrinkage percentage (\%)}$$

$$= (1-D1/D2)\times100 \quad \ldots\ldots(1)$$

In the present invention, the product obtained by the curing means a cured product having a (meth) acryloyl reaction rate of not less than 70 %.

In the present invention, exemplary methods for controlling the volumetric curing shrinkage percentage of the (meth)acrylic photo-curable composition (i) at 6 to 8 % include a method in which a single (meth) acrylic compound having a volumetric shrinkage percentage of 6 to 8 % is used, a method in which a plurality of (meth)acrylic compounds are used in combination, a method in which a filler is added, and a method in which the reaction rate is controlled during the curing. Among these methods, the method using the single (meth)acrylic compound having a volumetric shrinkage percentage of 6 to 8 % and the method using the plurality of (meth) acrylic compounds in combination are preferred for transparency and heat resistance. Particularly, the method using the plurality of (meth)acrylic compounds in combination is preferred, because the viscosity, the heat resistance and other physical properties can be controlled.

Examples of the (meth)acrylic compound having a volumetric shrinkage percentage of 6 to 8 % include di(meth) acrylates such as bis(hydroxy)tricyclo[5.2.1.0$^{2,6}$]decane-di(meth)acryl ate, bis(hydroxymethyl)tricyclo[5.2.1.0$^{2,6}$]decane-di(meth )acrylate, di(meth)acrylates of bisphenol-A type modified with ethylene oxide (2 to 4 mol) and polyethylene glycol (14 mol) di(meth)acrylates. Among these, bis(hydroxy)tricyclo[5.2.1.0$^{2,6}$]decane-di(meth)acryl ate, bis(hydroxymethyl) tricyclo[5.2.1.0$^{2,6}$]decane-di(meth )acrylate and di(meth)acrylates of bisphenol-A type modified with ethylene oxide (2 to 4 mol) are preferred for the heat resistance of the textured later. Bis(hydroxy)tricyclo[5.2.1.0$^{2,6}$]decane-di(meth)acryl ate and bis(hydroxymethyl)tricyclo[5.2.1.0$^{2,6}$]decane-di(meth )acrylate are particularly preferred for the viscosity.

Examples of the (meth) acrylic compounds to be used in combination for controlling the volumetric shrinkage percentage at 6 to 8 % include tricyclodecyl (meth)acrylate, ethylene glycol di(meth)acrylate, polyethylene glycol di(meth) acrylates, propylene glycol di(meth)acrylate, polypropylene glycol di (meth) acrylates, neopentyl glycol di (meth) acrylate, 1,6-hexanediol di(meth)acrylate, 1,9-nonanediol di(meth)acrylate, 1,10-decanediol di(meth)acrylate, bis(hydroxy)tricyclo[5.2.1.0$^{2,6}$]decane-di(meth)acryl ate, bis(hydroxymethyl)tricyclo[5.2.1.0$^{2,6}$]decane-di(meth )acrylate, di(meth)acrylates of bisphenol-A type modified with ethylene oxide, trimethylolpropane tri(meth)acrylate, pentaerythritol tri(meth) acrylate, pentaerythritol tetra(meth)acrylate and urethane (meth)acrylate compounds. Among these, di(meth)acrylates such as polyethylene glycol di(meth)acrylates, 1,6-hexanediol di(meth)acrylate, 1,9-nonanediol di(meth)acrylate, 1,10-decanediol di(meth)acrylate, bis(hydroxy)tricyclo[5.2.1.0$^{2,6}$]decane-di(meth)acryl ate, bis(hydroxymethyl)tricyclo [5.2.1.0$^{2,6}$]decane-di(meth )acrylate and di(meth)acrylates of bisphenol-A type modified with ethylene oxide, tri- or more-functional (meth)acrylates such as trimethylolpropane tri(meth)acrylate and pentaerythritol tetra(meth)acrylate, and urethane di(meth)acrylate compounds are preferred for the heat resistance of the textured later. Particularly, polyethylene glycol di(meth)acrylates, 1,6-hexanediol di(meth)acrylate, bis(hydroxy)tricyclo[5.2.1.0$^{2,6}$]decane-di(meth)acryl ate, bis (hydroxymethyl)tricyclo[5.2.1.0$^{2,6}$]decane-di(meth )acrylate and di(meth)acrylates of bisphenol-A type modified with ethylene oxide (2 to 30 mol) are preferred for viscosity.

Where the (meth)acrylic compounds are used in combination, the blend ratio of the respective compounds is adjusted so as to control the volumetric curing shrinkage percentage of the composition at 6 to 8 %.

Where two compounds (a compound A having a volumetric curing shrinkage percentage Xa and a blend ratio Ya, and a compound B having a volumetric curing shrinkage percentage Xb and a blend ratio Yb) are used in combination, for example, the volumetric curing shrinkage percentage Xt of the composition is approximately calculated from the following expression (2) :

$$Xt=Xa\times Ya+Xb\times Yb \quad (Ya+Yb=1) \quad \ldots\ldots(2)$$

Where the compound A and the compound B have volumetric curing shrinkage percentages of 3% and 11%, respectively, and are blended in a ratio of 50 wt%/50 wt%, for example, the resulting photo-curable composition has a volumetric shrinkage percentage of about 7 %.

In the present invention, the (meth)acrylic photo-curable composition (i) preferably has a viscosity of 5 to 1000 mPa·s, more preferably 10 to 500 mPa·s, further more preferably 20 to 300 mPa·s, at 23°C. If the viscosity is too low, the releasability tends to be poorer. If the viscosity is too high, the transferability tends to be poorer.

The (meth)acrylic photo-curable composition (i) thus prepared is irradiated with activation energy radiation, preferably ultraviolet radiation, to be thereby photo-cured. Thus, the textured later [II] is provided.

In the present invention, the textured later [II] of the resin obtained by photo-curing the (meth) acrylic photo-curable composition (i) is formed on the glass plate [I]. Thus, the solar cell substrate is produced which includes the laminate of the glass plate [I] and the textured later [II].

The textured later [II] thus formed by photo-curing the (meth)acrylic photo-curable composition (i) is free from a transfer defect, which may otherwise occur when the gravure printing process is performed by using a solution or a rectangular pattern is formed by a photo process. Thus, the textured later [II] can be highly precisely formed by the photo-curing. In addition, the textured later formation step is simplified.

For the production of the substrate including the laminate of the glass plate [I] and the textured later [II], the (meth)acrylic photo-curable composition (i) is applied onto a support base (matrix die) having a fine undulation pattern having a surface roughness (RMS) of 10 to 300 nm as measured at 256 measurement points in a 2-$\mu$m square measurement range by an atomic force microscope (AFM), and then the glass plate [I] is placed on the applied (meth)acrylic photo-curable composition (i). In turn, the (meth)acrylic photo-curable composition (i) is irradiated with activation energy radiation through the glass plate [I] and/or the support base (matrix die) to be thereby cured, and then the support base (matrix die) is removed from the textured later [II]. Thus, the substrate including the laminate of the glass plate [I] and the textured later [II] is produced. A coating agent such as a silane coupling agent may be preliminarily applied onto the glass plate [I] for improvement of adhesion between the glass plate [I] and the textured later [II].

At this time, the support base is required to have the fine undulation pattern. The fine undulation pattern preferably has a surface roughness of 10 to 300 nm, particularly preferably 10 to 200 nm, more preferably 15 to 100 nm, as measured at the 256 measurement points in the 2-$\mu$m square measurement range by the atomic force microscope (AFM). If the surface roughness (RMS) is too small or too great, the photo-electric conversion efficiency tends to be reduced.

The support base is preferably composed of glass or a metal for strength and heat resistance, and is particularly preferably composed of glass for transparency.

Specific examples of the support base include laminates including a metal oxide layer formed on a glass base as having a fine undulation pattern and commercially available under "A180U80 and "A110U80" from Asahi Glass Co., Ltd., and a textured glass base available from Nippon Sheet Glass Co., Ltd. The support base may be prepared by treating a glass base with hydrofluoric acid, or by roughening a surface of a glass base through a sand blast process by blasting particles onto the glass base. Alternatively, the support base may be prepared by transferring a pattern having an excellent light confinement property from a matrix die onto a metal or resin base by electro-casting. Among these support bases, "A180U80" commercially available from Asahi Glass Co., Ltd. is preferred because it has a higher light confinement capability in the visible range. The support base preferably has a plate shape for workability, but may have a roll shape for productivity.

For improvement of the releasability of the product obtained by photo-curing the photo-curable composition, a surface of the above support base to be brought into contact with the photo-cured product for the formation of the textured later [II] may be preliminarily coated with a release agent in the present invention. The release agent is not particularly limited, but a fluorine-containing release agent is preferred for releasability. For durability in repeated use of the support base, the release agent is preferably a silane coupling agent containing a fluorinated alkyl group.

For the curing of the (meth) acrylic photo-curable composition, the (meth)acrylic photo-curable composition is irradiated with ultraviolet radiation at an illuminance of 20 to 1000 mW/cm$^2$, particularly preferably 50 to 500 mW/cm$^2$, and at a light intensity of 1 to 20 J/cm$^2$, particularly preferably 2 to 10 J/cm$^2$.

After the irradiation, the support base is removed, and the resulting substrate is typically heated in a vacuum oven at 50°C to 200°C for 10 minutes to 6 hours, preferably at 100°C to 150°C for 20 minutes to 1 hour, for reduction of volatile gas.

In this manner, the laminate is provided which includes the textured later [II] formed on the surface of the glass plate [I] as having the undulation pattern, and the solar cell substrate is produced by utilizing the laminate.

The undulation pattern of the textured later [II] preferably has a surface roughness (RMS) of 10 to 300 nm, more preferably 10 to 200 nm, particularly preferably 15 to 100 nm, as measured at 256 measurement points in a 2-$\mu$m square measurement range by an atomic force microscope (AFM). If the surface roughness is too small or too great, the photo-electric conversion efficiency of the solar cell tends to be reduced.

The textured later [II] preferably has a glass transition temperature of not lower than 100°C, particularly preferably not lower than 150°C, more preferably not lower than 200°C. If the glass transition temperature is too low, the undulation pattern of the formed textured later is liable to be lost during the fabrication of the solar cell. The upper limit of the glass transition temperature is typically 500°C.

In the present invention, a film of a metal oxide is formed on the textured later [II] of the thus formed laminate including the glass plate [I] and the textured later [II] having the undulation pattern, whereby an electrode substrate is provided.

Examples of the metal oxide to be used in the present invention include: mono-metal oxides such as zinc oxide, tin oxide, indium oxide and titanium oxide; poly-metal oxides such as indium tin oxide, indium zinc oxide, indium titanium oxide and tin cadmium oxide; and doped metal oxides such as gallium-doped zinc oxide, aluminum-doped zinc oxide, boron-doped zinc oxide, titanium-doped zinc oxide, titanium-doped indium oxide, zirconium-doped indium oxide and fluorine-doped tin oxide. Among these, gallium-doped zinc oxide, aluminum-doped zinc oxide and boron-doped zinc oxide are preferred for easy film formation.

The formation of the metal oxide film is preferably achieved, for example, by a dry process at not lower than 150°C. If the temperature is too low, it is difficult to activate a dopant such as gallium, aluminum or boron, and the crystallinity is liable to be reduced to increase the sheet resistance. The sheet resistance is preferably not higher than 50 ohms per square, more preferably not higher than 40 ohms per square, particularly preferably not higher than 30 ohms per square.

Examples of the dry process herein employed include a sputtering method, a CVD method and a deposition method. From the viewpoint of the adhesion to the textured later [II], it is preferred to employ the sputtering method for the formation of the metal oxide film in the present invention.

The metal oxide film typically has a thickness of 100 to 1000 nm, preferably 130 to 700 nm, particularly preferably 150 to 500 nm. If the thickness is too small, the sheet resistance tends to be increased. If the thickness is too great, the time required for the formation of the film is increased. In addition, the light transmittance tends to be reduced, thereby reducing the photo-electric conversion efficiency.

In the present invention, the substrate is produced by forming the metal oxide film on the textured later [II] of the laminate including the glass plate [I] and the textured later [II] having the undulation pattern as described above. Alternatively, the substrate may be produced, for example, by using the (meth)acrylic photo-curable composition (i), applying the (meth)acrylic photo-curable composition (i) onto a support plate having a fine undulation pattern, placing a smooth support plate on an opposing surface of the applied (meth) acrylic photo-curable composition, photo-curing the (meth)acrylic photo-curable composition by irradiation with the activation energy radiation to form the textured later [II], removing the support plates from opposite sides of the textured later [II], forming a metal oxide film on the textured later [II] to provide a laminate including the textured later [II] and the metal oxide film, and stacking the glass plate [I] on a surface of the textured later [II] of the laminate opposite from the metal oxide film. When the glass plate [I] is stacked on the textured later [II], the glass plate [I] is bonded to the textured later [II] by heat and pressure or with an adhesive agent for laminating.

In the present invention, a gas barrier film may be provided on the textured later [II] of the solar cell substrate including the laminate of the glass plate [I] and the textured later [II].

The gas barrier film is a film that blocks oxygen and moisture. The gas barrier film is preferably composed of a material consisting essentially of silicon oxide or silicon nitride. A film formation method is not particularly limited, but a deposition method or a sputtering method is preferred. The gas barrier film may have a multilayer structure.

The gas barrier film preferably has a film thickness of 5 to 500 nm, more preferably 10 to 100 nm, further more preferably 15 to 50 nm. If the thickness is too small, the gas barrier property tends to be insufficient. On the other hand, if the thickness is too great, the substrate is liable to be cracked when being bent.

The gas barrier property is preferably such that the water vapor permeability is not greater than $1 \text{ g/day} \cdot \text{atm} \cdot \text{m}^2$, more preferably not greater than $0.5 \text{ g/day} \cdot \text{atm} \cdot \text{m}^2$, further more preferably not greater than $0.1 \text{ g/day} \cdot \text{atm} \cdot \text{m}^2$. If the water vapor permeability is too great, the solar cell tends to be less reliable. The lower limit of the water vapor permeability is typically $0.0001 \text{ g/day} \cdot \text{atm} \cdot \text{m}^2$.

An anti-fouling film and/or an anti-reflective film may be provided on a surface of the glass plate [I] opposite from the textured later [II] of the substrate having the layered structure including the glass plate [I] and the textured later [II] according to the present invention.

The anti-reflective film is preferably provided in an interface between the glass plate [I] and the atmosphere. Examples of the anti-reflective film include a fluororesin film having a lower refractive index, and a dielectric multilayer film including a silicon oxide film and a titanium oxide film stacked one on the other. Among these, the fluororesin film is preferred, which is inexpensive and has an anti-fouling function. The film formation method is not particularly limited, but a wet process such as a spin coating method or a die coating method is preferred.

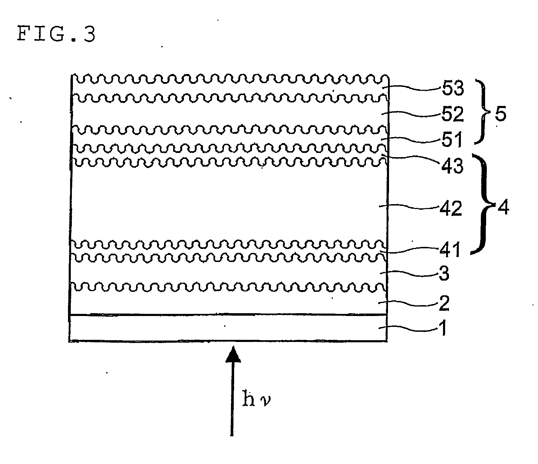

A solar cell employing the inventive solar cell substrate and a solar cell production method according to embodiments of the present invention will be described with reference to Fig. 3. In the embodiments, a superstrate type solar cell will be described as an example of a thin film silicon solar cell, but the invention is applicable to a substrate type solar cell and other types of thin film silicon solar cells.

First, the construction of the inventive solar cell will be described.

Fig. 3 is a sectional view showing the construction of a solar cell according to the embodiment of the present invention. The solar cell is a superstrate type solar cell. The solar cell includes a glass plate 1, a textured later 2, a metal oxide film 3, a photo-electric conversion layer 4 and a back reflective electrode layer 5. Light hv is incident on the solar cell on the side of the glass plate 1, and photo-electric conversion occurs in the solar cell.

The photo-electric conversion layer 4 includes a p-type layer 41, an i-type layer 42, an n-type layer 43. The n-type layer 43 is not necessarily required.

The p-type layer 41 is a window layer of the solar cell provided on the metal oxide film 3. Exemplary materials for the p-type layer 41 include amorphous silicon (a-Si) containing an impurity of a Group III element such as boron, amorphous silicon carbide (a-SiC), microcrystalline silicon and microcrystalline silicon carbide. The p-type layer 41 has a thickness of 0.5 to 100 nm. The p-type layer 41 is formed by at least one method selected from an atmospheric pressure or reduced pressure plasma CVD method, a CVD method using a heat catalyst, a thermal CVD method and a reactive sputtering method.

The i-type layer 42 is provided on the p-type layer 41. Exemplary materials for the i-type layer 42 include $\alpha$-Si doped with no impurity, microcrystalline silicon, amorphous silicon germanium and microcrystalline silicon germanium. The i-type layer 42 has a thickness of 100 to 10000 nm. The i-type layer 42 is formed by at least one method selected from an atmospheric pressure or reduced pressure plasma CVD method, a CVD method using a heat catalyst, a thermal CVD method and a reactive sputtering method.

The n-type layer 43 is provided on the i-type layer 42. Exemplary materials for the n-type layer 43 include $\alpha$-Si containing an impurity of a Group V element such as phosphorus, a-SiC, microcrystalline silicon, microcrystalline silicon carbide. Where the n-type layer 43 is provided, the n-type layer 43 has a thickness of 0.5 to 500 nm. The n-type layer 43 is formed by at least one method selected from an atmospheric pressure or reduced pressure plasma CVD method, a CVD method using a heat catalyst, a thermal CVD method and a reactive sputtering method.

The p-i-n silicon photo-electric conversion layer 4 is thus formed through the silicon thin film formation process described above. The photo-electric conversion layer 4 may be a single p-i-n-type layer but, where the photo-electric conversion layer 4 is a p-i-n/p-i-n stack photo-electric conversion layer or a p-i-n/p-i-n/p-i-n stack photo-electric conversion layer in which any of the aforementioned silicon materials is used for the i-type layer, a higher conversion efficiency is ensured.

The back reflective electrode layer 5 has higher electrical conductivity and higher reflectivity, and includes a transparent electrically conductive film 51, a back metal electrode 52 and a metal oxide film 53. The transparent electrically conductive film 51 is provided on the outermost n-type layer 43 of the photo-electric conversion layer 4. The provision of the transparent electrically conductive film 51 improves infrared reflectivity, and prevents diffusion of the back metal electrode 52 into the photo-electric conversion layer 4. For example, the transparent electrically conductive film 51 is preferably composed of a material consisting essentially of tin oxide, zinc oxide, indium oxide or the like.

The back metal electrode 52 is provided on the transparent electrically conductive film 51. The back metal electrode 52 has higher reflectivity in the visible to infrared range, and has higher electrical conductivity. For example, the back metal electrode 52 is preferably composed of a single metal selected from Ag, Au, Al, Cu and Pt, or an alloy containing any of these metals.

The metal oxide film 53 is provided on the back metal electrode 52. The metal oxide film 53 covers the back metal electrode 52 to prevent corrosion of the back metal electrode 52 which may otherwise occur when the back metal electrode 52 is exposed to air. For example, the metal oxide film 53 is preferably composed of a material consisting essentially of tin oxide, zinc oxide, indium oxide or the like.

EXAMPLES

The present invention will be described more specifically by way of examples. The invention is not limited to these examples without departing from the scope of the present invention.

Unless otherwise specified, "parts" and "%" used in the following examples are based on weight.

Physical properties were measured in the following manner.

(1) Observation with Atomic Force Microscope, Surface Roughness (RMS) (nm) and Maximum Level Difference (H)

A 1-cm square sample was cut out of a solar cell substrate, and the sample was measured in a contact mode by means of Nanopics 2100 available from SII Nano Technology Inc. The sample was set on a horizontal sample table. Then, a 10-$\mu$m square area of a surface (undulated surface) of the sample was observed, and the surface roughness RMS and the maximum level difference H (see Fig. 1) were measured in a given 10-$\mu$m wide area.

(2) Observation with Electronic Microscope

A 1-cm square sample was cut out thicknesswise of a solar cell substrate from a center portion of the solar cell substrate about an intersection of diagonal lines in a plane of the solar cell substrate, and a sectional surface of the sample was smoothly polished by a broad ion beam method. The sectional surface was observed at a magnification of X40,000 by means of an electronic microscope JSM-6600 available from JEOL Ltd. (see Fig. 2). Then, an undulation pattern of an undulated surface of a textured later [II] was measured. A distance L was defined as a distance between two points at which a line drawn parallel to a surface of a glass plate so as to allow an adjacent projection and depression of the textured later [II] to have the same sectional area intersects an undulation profile of the textured later [II] on opposite sides of the depression, and the number of depressions each having a distance L of greater than 1.5 μm in a given 10-μm wide area of the sectional surface was determined.

(3) Volumetric Curing Shrinkage Percentage of Photo-Curable Resin Composition (%)

The volumetric curing shrinkage percentage was calculated from the following expression (1) by using the specific gravity (D1) of a photo-curable composition and the specific gravity (D2) of a product obtained by curing the photo-curable composition:

$$\text{Volumetric shrinkage percentage (\%)}$$
$$= (1-D1/D2)\times100 \quad .....(1)$$

(4) Viscosity (mPa·s)

The viscosity was measured at 23°C with a rotation speed of 60 rpm (No. 3 rotor) using B-type viscometer BISMETRON VS-A1 available from Shibaura System Co., Ltd.

(5) Glass Transition Temperature

By using a test sample having a length of 30 mm and a width of 3 mm, the glass transition temperature was measured by a tensile method TMA (with a support point distance of 20 mm with a load of 100 g at a temperature rising rate of 5°C/min at a nitrogen flow rate of 140 ml/min) by means of TMA120 available from Seiko Instruments Inc.

(6) Photo-Electric Conversion Efficiency

The current and the voltage of a solar cell having a size of 0.5 cm × 0.5 cm (0.25 cm$^2$) were measured with an AM (air mass) of 1.5 with irradiation with light at 100 mW/cm$^2$ by using a solar simulator. The photo-electric conversion efficiency (%) was determined based on the results of measurement of the short circuit current, the open end voltage and the fill factor.

Example 1

Preparation of (Meth)acrylic Photo-Curable Composition (i-1)

A photo-curable composition (i-1) was prepared by homogeneously mixing 50 parts of bisphenol-A dimethacrylate modified with ethylene oxide (modified with 5 mol of ethylene oxide) (BPE-500 available from Shin-Nakamura Chemical Co., Ltd.), 50 parts of trimethylolpropane acrylate (A-TMPT available from Shin-Nakamura Chemical Co., Ltd.), 1 part of 1-hydroxycyclohexyl phenyl ketone (Irgacure 184 available from Ciba Geigy Corporation) as a photopolymerization initiator and 0.5 parts of tetrakis[methylene-3-(3',5'-di-t-butyl-4-hydroxyphenyl)propionate]methane (Irganox 1010 available from Ciba Geigy Corporation) as an antioxidant at 60°C with stirring. The composition thus prepared had a viscosity of 300 mPa·s and a volumetric shrinkage percentage of 7.8 %.

Preparation of Texture Formation Support Base

A glass base (A180U80 available from Asahi Glass Co., Ltd. and having a size of 350 mm x 300 mm) having an undulation pattern (texture pattern) formed from tin oxide on one surface thereof was prepared, and a 10-nm thick silicon oxide film was formed on the textured surface of the glass base by a sputtering method. Further, a fluorine-containing release agent (OPTOOL DSX available from Daikin Industries, Ltd.) was uniformly applied onto the textured surface, and air-dried. After the resulting glass base was allowed to stand in an environment at 60°C at 90%RH for 3 hours, the glass base was immersed in a fluorine-containing solvent (DEMNUM SOLVENT available from Daikin Industries, Ltd.) and ultrasonically cleaned at 23°C for 10 minutes. Thus, a texture formation support base was prepared. A textured surface of the base had a surface roughness (RMS) of 30 nm.

Production of Glass Plate [I]/Textured later [II] Laminate

The texture formation support base was placed with its texture surface facing up, and 2 g of the photo-curable composition (i-1) was uniformly applied dropwise on the support base along a line 2 cm inward of one edge of the support base at 23°C, and a blue glass plate (having a size of 350 mm x 300 mm and a thickness of 1.1 mm) was placed as a glass plate [I] on the texture formation support base with the photo-curable composition being spread over the entire surface of the support base for laminating by a laminator. The laminating rate was 0.5 m/min. Thereafter, the resulting stack was irradiated with ultraviolet radiation at an illuminance of 200 mW/cm$^2$ at a light intensity of 5 J/cm$^2$ by means of a metal halide lamp, and the support base was removed. Thus, a laminate including the glass plate [I] and a textured later [II] was produced.

The textured later [II] had a thickness of 2 $\mu$m, and an undulated surface of the textured later [II] had a surface roughness (RMS) of 30 nm.

Fabrication of Solar Cell

Next, a 5-cm square piece was cut out of the laminate, ultrasonically cleaned in 1-methoxy-2-acetoxypropane, and air-dried. The piece was fixed to a sputtering sample holder, which was in turn placed in a sputtering apparatus. The inside of the sputtering apparatus was evacuated to a pressure of 10$^{-5}$ Pa, and a substrate holder temperature was set at 150°C. Thereafter, argon gas was supplied into the sputtering apparatus at a flow rate of 100 sccm with the pressure adjusted at 5 mTorr. Then, a DC power of 400 W was supplied to a target of zinc oxide (ZnO) doped with 5.7 wt% of gallium oxide (Ga$_2$O$_3$). Thus, a transparent electrode substrate was produced, which included a thin film of gallium-doped zinc oxide (indicated by 3 in Fig. 3) formed on the laminate (indicated by 1 and 2 in Fig. 3) as having a thickness of 200 nm by sputtering.

Then, a sample of the transparent electrode substrate was set in a silicon deposition apparatus (CVD) of three-separate-layer type, and a photo-electric conversion layer (indicated by 4 in Fig. 3) was formed in the following manner.

Formation of p-Type Layer

The sample was carried into a p-type silicon deposition chamber, and then high purity semiconductor material gases such as silane (SiH$_4$), hydrogen (H$_2$), diborane (B$_2$H$_6$) and methane (CH$_4$) were supplied into the p-type silicon deposition chamber at constant flow rates. After the chamber was maintained at a pressure of 0.5 Torr with a substrate temperature kept at 150°C, electrical discharge was started, and a deposition process was performed for 1 minute. Thus, a 10-nm thick boron-doped a-Si alloy film (a p-type layer 41 in Fig. 3) was formed. Thereafter, the deposition process was performed under substantially the same conditions in the same chamber with only the supply of the diborane (B$_2$H$_6$) stopped. Thus, a 5-nm thick non-doped a-SiC alloy film was formed as a solar cell buffer layer. After the completion of the film formation, the chamber was evacuated again to higher vacuum.

Formation of i-Type Layer

After the sample was carried into an i-type silicon deposition chamber, SiH$_4$ and H$_2$ were supplied into the i-type silicon deposition chamber at constant flow rates. After the chamber was maintained at a higher pressure on the order of 1.0 Torr with a substrate temperature kept at 150°C, electrical discharge was started, and a deposition process was performed for 25 minutes. Thus, a 0.35-$\mu$m thick non-doped a-Si film (an i-type layer 42 in Fig. 3) was formed. After the completion of the film formation, the chamber was evacuated again to higher vacuum.

Formation of n-Type Layer

After the sample was carried into an n-type silicon deposition chamber, SiH$_4$, H$_2$ and phosphine (PH$_3$) were supplied into the n-type silicon deposition chamber at constant flow rates. The chamber was maintained at a pressure of 0.2 Torr with a substrate temperature kept at 150°C. Electrical discharge was started, and a deposition process was performed for 6 minutes. Thus, a 30-nm thick phosphorus-doped a-Si film (an n-type layer 43 in Fig. 3) was formed. After the completion of the film formation, the chamber was evacuated again to higher vacuum.

Formation of Back Reflective Electrode Layer

After the formation of a p-i-n three-layer photo-electric conversion unit, the sample was cooled to a room temperature, and taken out to the atmosphere. Then, the sample was placed again in the sputtering vacuum apparatus, and a back reflective electrode layer (indicated by 5 in Fig. 3) was formed in the following manner.

A 20-nm thick gallium-doped zinc oxide layer (indicated by 51 in Fig. 3), a 200-nm thick silver layer (indicated by 52 in Fig. 3) and a 20-nm thick gallium-doped zinc oxide layer (indicated by 53 in Fig. 3) were formed in this order on the sample at a room temperature. Then, the resulting sample was taken out of the vacuum apparatus, and these layers were patterned into a back electrode. Thus, a solar cell having an area of 0.25 cm$^2$ was fabricated. Thereafter, post-annealing was carried out at 150°C for 2 hours.

An amorphous silicon solar cell fabricate by the above process had a photo-electric conversion efficiency of 8 % as a result of measurement.

Example 2

Preparation of (Meth)acrylic Photo-Curable Composition (i-2)

A photo-curable composition (i-2) was prepared by homogeneously mixing 100 parts of bis(hydroxymethyl) tricyclo[5.2.1.0$^{2,6}$]decane-diacrylate (A-DCP available from Shin-Nakamura Chemical Co., Ltd.), 1 part of 1-hydroxycyclohexyl phenyl ketone (Irgacure 184 available from Ciba Geigy Corporation) as a photopolymerization initiator and 0.5 parts of tetrakis[methylene-3-(3',5'-di-t-butyl-4-hydroxyphenyl)propionate]methane (Irganox 1010 available from Ciba Geigy Corporation) as an antioxidant at 60°C with stirring. The composition thus prepared had a viscosity of 130 mPa·s and a volumetric shrinkage percentage of 6.4 %.

Preparation of Texture Formation Support Base

A texture formation support base was prepared in the same manner as in Example 1. A textured surface of the base had a surface roughness (RMS) of 30 nm.

Production of Glass Plate [I]/Textured later [II] Laminate

A laminate including a glass plate [I] and a textured later [II] was produced in the same manner as in Example 1.

The textured later [II] had a thickness of 2 μm, and an undulated surface of the textured later [It] had a surface roughness (RMS) of 30 nm.

Fabrication of Solar Cell

By using the laminate thus produced, an amorphous silicon solar cell was fabricated in the same manner as in Example 1. The solar cell thus fabricated had a photo-electric conversion efficiency of 8 % as a result of measurement.

Example 3

Preparation of Urethane Acrylate

In a four-neck flask provided with a thermometer, a stirrer, a water cooling condenser and a nitrogen gas inlet, 53.34 g (0.24 mol) of isophorone diisocyanate, 55.73 g (0.48 mol) of 2-hydroxyethyl acrylate, 0.02 g of hydroquinone methyl ether as a polymerization inhibitor, 0.02 g of dibutyltin dilaurate as a reaction catalyst and 500 g of methyl ethyl ketone were put and allowed to react at 60°C for 3 hours, and the reaction was terminated when the amount of residual isocyanate groups reached 0.3%. Then, the solvent was distilled away. Thus, a difunctional urethane acrylate was prepared.

Preparation of (Meth)acrylic Photo-CurableComposition (i-3)

A photo-curable composition (i-3) was prepared by homogeneously mixing 20 parts of the above difunctional urethane acrylate, 80 parts of trimethylolpropane acrylate (A-TMPT available from Shin-Nakamura Chemical Co., Ltd.), 1 part of 1-hydroxycyclohexyl phenyl ketone (Irgacure 184 available from Ciba Geigy Corporation) as a photopolymerization initiator and 0.5 parts of tetrakis[methylene-3-(3',5'-di-t-butyl-4-hydroxyphenyl)propionate]methane (Irganox 1010 available from Ciba Geigy Corporation) as an antioxidant at 60°C with stirring. The composition thus prepared had a viscosity of 700 mPa·s and a volumetric shrinkage percentage of 6.1 %.

Preparation of Texture Formation Support Base

A texture formation support base was prepared in the same manner as in Example 1. A textured surface of the base had a surface roughness (RMS) of 30 nm.

Production of Glass Plate [I]/Textured later [II] Laminate

A laminate including a glass plate [I] and a textured later [II] was produced in the same manner as in Example 1.
The textured later [II] had a thickness of 2 μm, and an undulated surface of the textured later [II] had a surface roughness (RMS) of 30 nm.

Fabrication of Solar Cell

By using the laminate thus produced, an amorphous silicon solar cell was fabricated in the same manner as in Example 1. The solar cell thus fabricated had a photo-electric conversion efficiency of 7 % as a result of measurement.

Comparative Example 1

Preparation of (Meth)acrylic Photo-Curable Composition (i-4)

A photo-curable composition (i-4) was prepared by homogeneously mixing 20 parts of bis(hydroxymethyl) tricyclo[$5.2.1.0^{2,6}$]decane-diacrylate (A-DCP available from Shin-Nakamura Chemical Co., Ltd.), 80 parts of pentaerythritol tetraacrylate (A-TMMT available from Shin-Nakamura Chemical Co., Ltd.), 1 part of 1-hydroxycyclohexyl phenyl ketone (Irgacure 184 available from Ciba Geigy Corporation) as a photopolymerization initiator and 0.5 parts of tetrakis [methylene-3-(3',5'-di-t-butyl-4-hydroxyphenyl)propionate]methane (Irganox 1010 available from Ciba Geigy Corporation) as an antioxidant at 60°C with stirring. The composition thus prepared had a viscosity of 200 mPa·s and a volumetric shrinkage percentage of 12.5 %.

Preparation of Texture Formation Support Base

A texture formation support base was prepared in the same manner as in Example 1. A textured surface of the base had a surface roughness (RMS) of 30 nm.

Production of Glass Plate [I]/Textured later [II] Laminate

A laminate including a glass plate [I] and a textured later [II] was produced in the same manner as in Example 1.
The textured later [II] had a thickness of 2 μm, and an undulated surface of the textured later [II] had a surface roughness (RMS) of 30 nm.

Fabrication of Solar Cell

By using the laminate thus produced, an amorphous silicon solar cell was fabricated in the same manner as in Example 1. The solar cell thus fabricated had a photo-electric conversion efficiency of 5 % as a result of measurement.

Comparative Example 2

Preparation of Urethane Acrylate

In a four-neck flask provided with a thermometer, a stirrer, a water cooling condenser and a nitrogen gas inlet, 53.34 g (0.24 mol) of isophorone diisocyanate, 55.73 g (0.48 mol) of 2-hydroxyethyl acrylate, 0.02 g of hydroquinone methyl ether as a polymerization inhibitor, 0.02 g of dibutyltin dilaurate as a reaction catalyst and 500 g of methyl ethyl ketone were put and allowed to react at 60°C for 3 hours, and the reaction was terminated when the amount of residual isocyanate groups reached 0.3%. Then, the solvent was distilled away. Thus, a difunctional urethane acrylate was prepared.

Preparation of (Meth)acrylic Photo-Curable Composition (i-5)

A photo-curable composition (i-5) was prepared by homogeneously mixing 100 parts of the above difunctional urethane acrylate, 1 part of 1-hydroxycyclohexyl phenyl ketone (Irgacure 184 available from Ciba Geigy Corporation) as a photopolymerization initiator and 0.5 parts of tetrakis[methylene-3-(3',5'-di-t-butyl-4-hydroxyphenyl)propionate] methane (Irganox 1010 available from Ciba Geigy Corporation) as an antioxidant at 60°C with stirring. The composition thus prepared had a viscosity of 200,000 mPa·s and a volumetric shrinkage percentage of 3.0 %.

Preparation of Texture Formation Support Base

A texture formation support base was prepared in the same manner as in Example 1. A textured surface of the base had a surface roughness (RMS) of 30 nm.

Production of Glass Plate [I]/Textured later [II]

Laminate

A laminate including a glass plate [I] and a textured later [II] was produced in the same manner as in Example 1.
The textured later [II] had a thickness of 2 μm, and an undulated surface of the textured later [II] had a surface roughness (RMS) of 30 nm.

Fabrication of Solar Cell

By using the laminate thus produced, an amorphous silicon solar cell was fabricated in the same manner as in Example 1. The solar cell thus fabricate had a photo-electric conversion efficiency of 5 % as a result of measurement.
Evaluation results of Examples and Comparative Examples are shown in Table 1.

Table 1 (Textured later [II] and Solar Cell)

|  | Example | | | Comparative Example | |
|---|---|---|---|---|---|
|  | 1 | 2 | 3 | 1 | 2 |
| Textured later [II] | | | | | |
| Photo-curable composition | i-1 | i-2 | i-3 | i-4 | i-5 |
| Volumetric curing shrinkage percentage (%) | 7.8 | 6.4 | 6.1 | 12.5 | 3.0 |
| Viscosity of photo-curable composition (mPa·s) | 300 | 130 | 700 | 200 | 200,000 |
| Glass transition temperature (°C) | 200 | 240 | 240 | >300 | 170 |
| Surface roughness (RMS) (nm) | 30 | 30 | 30 | 30 | 30 |
| The number of depressions in condition (A) | 0 | 0 | 1 | 3 | 3 |
| Maximum level difference of undulation pattern in condition (B) (μm) | 0.1 | 0.1 | 0.1 | 0.2 | 0.4 |
| The number of depressions in condition (C) | 0 | 0 | 1 | 4 | 3 |
| Solar cell | | | | | |
| Photo-electric conversion efficiency (%) | 8 | 8 | 7 | 5 | 5 |

As apparent from Table 1, the solar cells of Examples satisfying the conditions (A) and (B) are excellent in photo-electric conversion efficiency. In contrast, the solar cells of Comparative Examples not satisfying the conditions (A) and/or (B) fail to have satisfactory photo-electric conversion efficiency.
The solar cells of Examples each have a photo-electric conversion efficiency of 7 to 8, while the solar cells of Comparative Examples each have a photo-electric conversion efficiency of 5. Therefore, there seems to be little numerical difference in photo-electric conversion efficiency between Examples and Comparative Examples. Even with this numerical difference, the solar cells of Examples are each expected to have an electric power generation capability improved by not less than 40% over the solar cells of Comparative Examples when being installed. This makes a significant difference.

INDUSTRIAL APPLICABILITY

The inventive solar cell substrates are each excellent in photo-electric conversion efficiency, and useful as a substrate for a solar cell.

**Claims**

1. A solar cell substrate comprising a laminate including a glass plate [I] and a textured later [II], wherein the textured later [II] is composed of a resin obtained by curing a (meth)acrylic photo-curable composition (i), wherein a 1-cm square substrate center portion (a) of the solar cell substrate satisfies the following conditions (A) and (B):

   (A) an undulated surface of the textured later [II] in the substrate portion (a) has not more than two depressions each having a diameter of greater than 1.5 $\mu$m as observed in a 10-$\mu$m square field of view by an electronic microscope (SEM); and
   (B) the undulated surface of the textured later [II] in the substrate portion (a) has a maximum level difference of not greater than 0.3 $\mu$m as observed in a 10-$\mu$m square field of view by an atomic force microscope (AFM).

2. A solar cell substrate comprising a laminate including a glass plate [I] and a textured later [II], wherein the textured later [II] is composed of a resin obtained by curing a (meth)acrylic photo-curable composition (i), wherein a 1-cm square substrate center portion (a) of the solar cell substrate satisfies the following condition (C):

   (C) where a distance L is defined as a distance between two points at which a line drawn parallel to a surface of the glass plate so as to allow an adjacent projection and depression of the textured later [II] to have the same sectional area intersects an undulation profile of the textured later [II] on opposite sides of the depression in a section of the substrate portion (a) taken in a thicknesswise direction as observed by an electronic microscope (SEM) to measure an undulation pattern of the textured later [II] opposite from the glass plate [I], not more than two depressions each having a distance L greater than 1.5 $\mu$m are present in a given 10-$\mu$m wide area of the section of the substrate portion (a).

3. A solar cell substrate as set forth in claim 1 or 2, wherein the (meth) acrylic photo-curable composition (i) has a volumetric curing shrinkage percentage of 6 to 8 %.

4. A solar cell substrate as set forth in any of claims 1 to 3, wherein the (meth)acrylic photo-curable composition (i) has a viscosity of 5 to 1000 mPa·s at 23°C.

5. A solar cell substrate as set forth in any of claims 1 to 4, wherein the textured later [II] has a glass transition temperature of not lower than 200°C.

6. A solar cell substrate as set forth in any of claims 1 to 5, wherein the textured later [II] has a thickness of 0.3 to 30 $\mu$m.

7. A solar cell substrate as set forth in any of claims 1 to 6, wherein the undulated surface of the textured later [II] has an RMS surface roughness of 10 to 300 nm as measured at 256 measurement points in a 2-$\mu$m square measurement range by an atomic force microscope (AFM).

8. A solar cell comprising a solar cell substrate as recited in any of claims 1 to 7.

FIG.1

←————— 1 0 μm —————→

FIG.2

TEXTURE PROFILE (LINE 2)

SECTIONAL AREA OF PROJECTION

PARALLEL LINE (LINE 1)

SECTIONAL AREA OF DEPRESSION

DEPRESSION

PROJECTION

PROJECTION

PROJECTION

DEPRESSION

TEXTURE LAYER [II]

DEPRESSION

GLASS PLATE [I]

FIG.3

**EP 2 261 998 A1**

## INTERNATIONAL SEARCH REPORT

| International application No. |
|---|
| PCT/JP2009/052373 |

### A. CLASSIFICATION OF SUBJECT MATTER
*H01L31/04*(2006.01)i

According to International Patent Classification (IPC) or to both national classification and IPC

### B. FIELDS SEARCHED
Minimum documentation searched (classification system followed by classification symbols)
H01L31/04

Documentation searched other than minimum documentation to the extent that such documents are included in the fields searched
Jitsuyo Shinan Koho       1922-1996   Jitsuyo Shinan Toroku Koho   1996-2009
Kokai Jitsuyo Shinan Koho   1971-2009   Toroku Jitsuyo Shinan Koho   1994-2009

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | WO 2008/026322 A1 (National Institute of Advanced Industrial Science and Technology), 06 March, 2008 (06.03.08), Par. Nos. [0035], [0055], [0062], [0066], [0090], [0126] to [0127] (Family: none) | 1-8 |
| A | JP 62-209872 A (Fuji Electric Corporation Research and development Ltd.), 16 September, 1987 (16.09.87), Page 1, right column (Family: none) | 1-8 |

☒ Further documents are listed in the continuation of Box C.      ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search 02 March, 2009 (02.03.09) | Date of mailing of the international search report 10 March, 2009 (10.03.09) |
|---|---|
| Name and mailing address of the ISA/ Japanese Patent Office | Authorized officer |
| Facsimile No. | Telephone No. |

Form PCT/ISA/210 (second sheet) (April 2007)

21

**INTERNATIONAL SEARCH REPORT**

| International application No. |
| --- |
| PCT/JP2009/052373 |

C (Continuation).   DOCUMENTS CONSIDERED TO BE RELEVANT

| Category* | Citation of document, with indication, where appropriate, of the relevant passages | Relevant to claim No. |
| --- | --- | --- |
| A | JP 9-69642 A  (Semiconductor Energy Laboratory Co., Ltd.),<br>11 March, 1997 (11.03.97),<br>Par. Nos. [0006], [0044]<br>& US 5711824 A          & US 5891264 A | 1-8 |
| A | JP 2002-280590 A  (Sharp Corp.),<br>27 September, 2002 (27.09.02),<br>Par. No. [0020]<br>& US 2002/0134425 A1 | 1-8 |
| A | JP 2005-150242 A  (Japan Gore-Tex Inc.),<br>09 June, 2005 (09.06.05),<br>Examples<br>(Family: none) | 1-8 |
| A | JP 2001-232729 A  (Mitsubishi Chemical Corp.),<br>28 August, 2001 (28.08.01),<br>Full text; all drawings<br>(Family: none) | 1-8 |

Form PCT/ISA/210 (continuation of second sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003298085 A
- JP 2003298086 A
- JP 2003298084 A
- JP 3792281 B